# EUROPÄISCHE PATENTSCHRIFT

(11) **EP 3 417 493 B1**
(45) Veröffentlichungstag und Bekanntmachung des Hinweises auf die Patenterteilung: **15.04.2020**
(21) Anmeldenummer: 17704434.4
(22) Anmeldetag: 07.02.2017
(51) Int. Cl.: H01L 41/107, H05H 1/24

(54) **VORRICHTUNG ZUR ERZEUGUNG EINES ATMOSPHÄRENDRUCK-PLASMAS MITTELS EINES PIEZOELEKTRISCHEN TRANSFORMATORS**
DEVICE FOR GENERATING AN ATMOSPHERIC PRESSURE PLASMA WITH A PIEZOELECTRIC TRANSFORMER
DISPOSITIF POUR GÉNÉRER UN PLASMA A PRESSION ATMOSPHERIQUE PAR UN TRANSFORMATEUR PIÉZOÉLECTRIQUE

(30) Priorität: 15.02.2016 DE 102016102585
(43) Veröffentlichungstag der Anmeldung: 26.12.2018
(73) Patentinhaber: TDK Electronics AG, 81671 München (DE)
(72) Erfinder: KUDELA, Pavol, 8530 Deutschlandsberg (AT); RINNER, Franz, 8530 Deutschlandsberg (AT); PUFF, Markus, 8010 Graz (AT)
(74) Vertreter: Epping - Hermann - Fischer
(86) Internationale Anmeldenummer: PCT/EP2017/052615
(87) Internationale Veröffentlichungsnummer: WO 2017/140531

(56) Entgegenhaltungen:
- WO-A2-03/096521
- DE-A1-102014 110 405
- DE-U1-202008 008 980
- US-A1- 2015 373 824

## Beschreibung

Die vorliegende Erfindung betrifft eine Vorrichtung zur Erzeugung eines Atmosphärendruck-Plasmas. Dabei handelt es sich um ein nicht-thermisches Plasma.

Die Vorrichtung weist insbesondere einen piezoelektrischen Transformator auf, der eine Ausgangsspannung erzeugt, die zur Ionisation eines Prozessgases genutzt werden kann. Die Vorrichtung sollte Bewegungen des piezoelektrischen Transformators, insbesondere in longitudinaler Richtung, relativ zu einer Halterung der Vorrichtung zu vermeiden. Gleichzeitig sollte die Halterung jedoch den piezoelektrischen Transformator nicht derart beeinträchtigen, dass Schwingungen des Transformators gedämpft werden, da dadurch die Effizienz der Plasmaerzeugung reduziert würde.

US 2015/373824 A1 beschreibt einen piezoelektrischen Transformator, der durch einen Halter gehalten wird, wobei der Halter mit einer Außenelektrode elektrisch kontaktiert ist.

DE 20 2008 008 980 U1 betrifft eine Vorrichtung zur Plasmaerzeugung, bei der ein Piezoelement mittels zweier Federklemmen festgeklemmt ist. Die Federklemmen sind ferner mit je einer Schraube an einer dielektrischen Endklappe fixiert.

Aufgabe der vorliegenden Erfindung ist es daher, eine Vorrichtung anzugeben, die diese einander zunächst widersprechenden Anforderungen möglichst gut erfüllt.

Die Aufgabe wird durch eine Vorrichtung gemäß dem vorliegenden Anspruch 1 gelöst.

Es wird eine Vorrichtung zur Erzeugung eines Atmosphärendruck-Plasmas vorgeschlagen, die einen piezoelektrischen Transformator, ein Kontaktelement und eine Halterung aufweist. Der piezoelektrische Transformator weist einen Eingangsbereich und einen Ausgangsbereich auf, wobei der Eingangsbereich dazu ausgestaltet ist, eine angelegte Wechselspannung in eine mechanische Schwingungen zu wandeln, wobei der Ausgangsbereich dazu ausgestaltet ist, eine mechanische Schwingung in eine elektrische Spannung zu wandeln und wobei der Ausgangsbereich sich in einer longitudinalen Richtung an den Eingangsbereich anschließt. Das Kontaktelement ist an dem piezoelektrischen Transformator befestigt und dazu ausgelegt, an den Eingangsbereich eine Wechselspannung anzulegen. Das Kontaktelement ist ferner durch eine formschlüssige Verbindung derart mit der Halterung verbunden, dass eine Bewegung des piezoelektrischen Transformators in longitudinaler Richtung relativ zu der Halterung verhindert wird.

Als "formschlüssige Verbindung" kann eine Verbindung von mindestens zwei Verbindungspartnern bezeichnet werden, die durch das Ineinandergreifen der mindestens zwei Verbindungspartner entsteht. Dabei können sich die Verbindungspartner auch ohne oder bei unterbrochener Kraftübertragung nicht voneinander lösen. Anders ausgedrückt wird bei einer formschlüssigen Verbindung eine Bewegung des einen Verbindungspartners durch den anderen Verbindungspartner in mindestens eine Richtung gesperrt. Bei Betriebsbelastung wirken Druckkräfte normal, das heißt rechtwinklig, zu den Flächen der Verbindungspartner. Im vorliegenden Fall bilden das Kontaktelement und die Halterung die Verbindungspartner der formschlüssigen Verbindung, wobei durch die Formgebung der Halterung eine Bewegung des Kontaktelements in longitudinaler Richtung gesperrt wird.

Eine Bewegung des piezoelektrischen Transformators in longitudinaler Richtung wird nicht dadurch verhindert, dass die Halterung unmittelbar mit dem piezoelektrischen Transformator verbunden wird, sondern dadurch, dass die Halterung mit dem Kontaktelement verbunden ist, welches wiederum an dem Transformator befestigt ist. Dadurch wird eine Vorrichtung geschaffen, bei der die mechanische Befestigung des Kontaktelements mit dem piezoelektrischen Transformator nur geringen mechanischen Belastungen ausgesetzt ist. Somit kann beispielsweise die Lebensdauer von Lötstellen, an denen das Kontaktelement an die Außenelektroden gelötet ist, erheblich verlängert werden.

Außerdem dämpft die Halterung auf diese Weise nicht die Schwingungen des piezoelektrischen Transformators in longitudinaler Richtung, da die Halterung nicht unmittelbar auf den piezoelektrischen Transformator einwirkt. Dementsprechend kann Plasma mit einer hohen Effizienz erzeugt werden.

Die formschlüssige Verbindung kann insbesondere stoßfest sein, sodass beispielsweise auch ein Herunterfallen der Vorrichtung nicht zu einer longitudinalen Bewegung des piezoelektrischen Transformators relativ zu der Halterung führen würde.

Die Halterung kann somit mehreren Zwecken gleichzeitig dienen. Durch ihre formschlüssige Verbindung mit dem Kontaktelement kann sie den piezoelektrischen Transformator in seiner longitudinalen Position fixieren. Gleichzeitig ist sie so konstruiert, dass sie die Schwingungen des piezoelektrischen Transformators nicht oder zumindest nur minimal dämpft, da die Fixierung über den Formschluss mit dem Kontaktelement diese Schwingungen des Transformators nicht wesentlich beeinträchtigt. Ferner kann die Halterung als mechanischer Schutz des Transformators dienen, beispielsweise gegen Stöße.

Die Halterung kann zwei Vorsprünge aufweisen, wobei das Kontaktelement in longitudinaler Richtung beidseitig unmittelbar an je einem der beiden Vorsprünge anliegt. Dementsprechend kann das Kontaktelement formschlüssig zwischen den beiden Vorsprüngen eingeschlossen sein.

Alternativ oder ergänzend kann die Halterung schlitzförmige Ausnehmungen aufweisen, in denen das Kontaktelement angeordnet ist und durch die das Kontaktelement aus einem Inneren der Halterung aus der Halterung herausgeführt wird. Auch durch die Anordnung der Kontaktelemente in den schlitzförmigen Ausnehmungen der Halterung kann eine formschlüssige Verbindung zwischen dem Kontaktelement und der Halterung geschaffen werden. Die schlitzförmigen Ausnehmungen können sich in longitudinaler Richtung erstrecken. In den Raumrichtungen senkrecht zur longitudinalen Richtung können die schlitzförmigen Ausnehmungen eine deutlich geringere Ausdehnung aufweisen als in longitudinaler Richtung.

Alternativ oder ergänzend kann das Kontaktelement zwei Drähte aufweisen, wobei die Halterung Öffnungen aufweist, deren Durchmesser einem Durchmesser der Drähte entspricht, wobei jeder der zwei Drähte durch je zwei Öffnungen in der Halterung verläuft und dadurch formschlüssig mit der Halterung verbunden ist. Der Durchmesser der Öffnungen kann insbesondere nur geringfügig größer sein als der Durchmesser der Drähte, so dass sich bei der Anordnung eines Drahts in der Öffnung ein Formschluss ergibt.

Das Kontaktelement ist an dem piezoelektrischen Transformator durch eine nicht-lösbare Befestigung befestigt. Als nicht-lösbare Befestigung können dabei alle Befestigungen bezeichnet werden, die sich nicht lösen lassen, ohne zumindest eines der miteinander befestigten Elemente dabei zu zerstören oder zumindest zu beschädigen.

Eine solche nicht-lösbare Befestigung des Kontaktelementes an dem piezoelektrischen Transformator kann beispielsweise durch Löten, Bonden, Kleben oder Mikrosilber-Sintern gefertigt werden. Bei dem Mikrosilber-Sintern wird eine Paste zwischen dem Kontaktelement und dem Transformator aufgebracht und anschließend werden das Kontaktelement und der Transformator miteinander gesintert. Bei dem Sinterprozess wird aus der Paste eine Schicht gebildet, die zu mindestens 95 Gew.-% aus Silber besteht und die das Kontaktelement und den piezoelektrischen Transformator mechanisch miteinander verbindet.

Die Halterung kann zumindest zwei Stützelemente aufweisen, auf denen der piezoelektrische Transformator aufliegt und die eine Bewegung des piezoelektrischen Transformators in eine Richtung senkrecht zur longitudinalen Richtung verhindern. Dabei handelt es sich um Bewegungen des piezoelektrischen Transformators relativ zu der Halterung.

Insbesondere kann die Halterung ein erstes Paar bestehend aus zwei Stützelementen und ein zweites Paar bestehend aus zwei Stützelementen aufweisen, wobei das erste Paar eine Bewegung des Transformators relativ zur Halterung in eine erste Richtung senkrecht zur longitudinalen Richtung verhindert und das zweite Paar eine Bewegung des Transformators relativ zur Halterung in eine zweite Richtung verhindert, die senkrecht zur longitudinalen Richtung und senkrecht zur ersten Richtung ist.

Die Stützelemente können dementsprechend Bewegungen des piezoelektrischen Transformators in Richtungen senkrecht zur longitudinalen Richtung verhindern, ohne dass dabei die Befestigungen des Kontaktelementes an dem piezoelektrischen Transformator, beispielsweise die Lötstellen, mechanisch belastet werden. Solche Bewegungen senkrecht zur longitudinalen Richtung können beispielsweise in Folge von Stößen ausgelöst werden.

Der Transformator kann auf den Stützelementen aufliegen, so dass die Stützelemente keine permanente Klemmwirkung auf den Transformator ausüben, sondern erst dann eine Kraft auf den Transformator ausüben, wenn dieser sich andernfalls relativ zu der Halterung senkrecht zur longitudinalen Richtung bewegen würde. Durch das Aufliegen auf den Stützelementen kann der Transformator somit daran gehindert werden, sich in eine Richtung senkrecht zur longitudinalen Richtung zu bewegen. Dadurch dass die Stützelemente keine permanente Kraft auf den Transformator ausüben, kann sichergestellt werden, dass die Stützelemente eine Schwingung des Transformators in longitudinale Richtung nicht dämpfen.

Die Stützelemente können eine in Richtung zu dem piezoelektrischen Transformator hin keilförmig zugespitzte Form aufweisen und an dem piezoelektrischen Transformator nahezu linienförmig anliegen. Dementsprechend liegen die Stützelemente nur mit einer minimalen Fläche an dem piezoelektrischen Transformator an. Auf diese Weise kann eine Dämpfung der Schwingung des Transformators durch die Stützelemente noch weiter reduziert werden.

Die Stützelemente können derart angeordnet sein, dass sie an dem piezoelektrischen Transformator in longitudinaler Richtung an einer Position anliegen, die einem Viertel oder drei Vierteln der Länge des piezoelektrischen Transformators entspricht. An diesen Positionen können bei Betrieb des piezoelektrischen Transformators mit seiner Resonanzfrequenz beziehungsweise mit einer harmonischen Oberschwingung der Resonanzfrequenz Schwingungsknoten ausgebildet werden. Dementsprechend bewegt sich der piezoelektrische Transformator bei Betrieb der Vorrichtung an diesen Positionen nur minimal. Die Anordnung der Stützelemente an diesen Positionen kann ebenfalls dazu beitragen, dass die Stützelemente die Schwingungen des piezoelektrischen Transformators nicht wesentlich dämpfen.

Die Halterung kann aus einem Material bestehen, das sich überwiegend elastisch verformt. Durch die überwiegende elastische Verformung kann sich insbesondere ein hoher Gütefaktor ergeben. Es kann sich bei dem Material insbesondere um ein hartes Material handeln. Insbesondere können die Stützelemente aus dem Material bestehen, das sich überwiegend elastisch verformt. Eine Halterung aus Gummi oder einem anderen sich plastisch verformenden Material würden zu einer Dämpfung der Schwingung des piezoelektrischen Transformators führen. Durch die Verwendung eines Materials, das sich überwiegend elastisch verformt, kann sichergestellt werden, sodass die Schwingungen des Transformators nicht mechanisch auf die Halterung übertragen werden können und dementsprechend nicht gedämpft werden.

Bei dem Material kann es sich beispielsweise um Polybutylenterephthalat (PBT), Polytetrafluorethylen (PTFE) oder ein Polyamid, das ferner Glasfaseranteile aufweisen kann, handeln.

Die Halterung kann zwei miteinander verbundenen Halbschalen aufweisen. Dabei kann eine Befestigung des piezoelektrischen Transformators beziehungsweise der Kontaktelemente durch die Verbindung der beiden Halbschalen erstellt werden.

Die beiden Halbschalen können identisch zueinander sein. Ferner können die beiden Halbschalen aus einem Material gefertigt sein. Insbesondere können die beiden Halbschalen mittels Spritzguss aus einer Spritzgussmasse gefertigt worden sein, wobei ein und dieselbe Form zur Fertigung der beiden Halbschalen verwendet werden kann. Durch die Verwendung einer Halterung, die aus zwei identischen Halbschalen besteht, kann somit ein einfaches Herstellungsverfahren ermöglicht werden, bei dem nur eine einzige Spritzgussform verwendet werden muss.

Das Kontaktelement kann ein Kupfer-Invar-Kupfer (CIC = Copper Invar Copper) aufweisendes Blech aufweisen. Kupfer-Invar-Kupfer weist den Vorteil eines sehr geringen thermischen Ausdehnungskoeffizienten auf. Ferner kann ein Kupfer-Invar-Kupfer aufweisendes Blech in verschiedene Formen gepresst werden und erlaubt dementsprechend eine hohe Designflexibilität bei der Ausgestaltung der Kontaktierung der Vorrichtung.

Das Blech kann einen ersten Abschnitt, der an dem piezoelektrischen Transformator anliegt, und einen zweiten Abschnitt, der an einer Außenseite der Halterung angeordnet ist, aufweisen. Dazu kann das Blech gebogen sein. Beispielsweise kann das Blech U-förmig gebogen sein. Alternativ kann das Blech derart gebogen sein, dass es rechtwinkelige Knicke aufweist, die die Abschnitte voneinander trennen.

Ferner kann die Halterung ein Führungselement aufweisen, dessen Form an die Form des Blechs angepasst ist. Beispielsweise können das Blech und das Führungselement jeweils einen halbkreisförmigen Abschnitt aufweisen. Das Blech und die Halterung können derart angeordnet sein, dass sich eine formschlüssige Verbindung von Blech und Halterung ergibt.

Das Blech kann ferner einen mittleren Abschnitt aufweisen, der den ersten Abschnitt mit dem zweiten Abschnitt verbindet, wobei das Blech U-förmig gebogen ist. Insbesondere kann der mittlere Abschnitt den halbkreisförmigen Bogen der U-Form ausbilden. Der erste und der zweite Abschnitt können jeweils gerade Schenkel der U-Form bilden.

Der zweite Abschnitt kann einen gebogenen Teilabschnitt aufweisen, der formschlüssig mit der Halterung verbunden ist. Diese formschlüssige Verbindung kann weiter dazu beitragen, Relativbewegungen zwischen dem Blech und der Halterung auszuschließen.

Ferner kann die Vorrichtung einen Steg aufweisen, der an einer eingangsseitigen Stirnseite des piezoelektrischen Transformators anliegt und dadurch eine Bewegung des piezoelektrischen Transformators in die longitudinale Richtung zu dem Steg hin verhindert. Der Steg kann beispielsweise zusammen mit dem Blech eine formschlüssige Verbindung zwischen der Halterung, dem Kontaktelement und dem Transformator ausbilden.

Ein weiterer Aspekt der vorliegenden Erfindung betrifft einen Plasmagenerator, der die oben beschriebene Vorrichtung und ein Gehäuse, in dem die Vorrichtung angeordnet ist, aufweist. Der Plasmagenerator kann insbesondere die Erzeugung eines nicht-thermischen Atmosphärendruck-Plasmas ermöglichen. Der Plasmagenerator kann neben der Vorrichtung und dem Gehäuse weitere Bauelemente aufweisen. Hierzu gehören beispielsweise eine Ansteuerschaltung, eine Düse, über die das Plasma austreten kann, und einen Einlass für ein Prozessgas.

Das Gehäuse kann ein Außengehäuse des Plasmagenerators sein. Die Halterung der Vorrichtung kann im Innern des Gehäuses angeordnet sein. Dementsprechend kann die Halterung nur dann zugänglich sein, wenn das Gehäuse geöffnet ist.

Die Vorrichtung kann vorzugsweise lösbar in dem Gehäuse befestigt sein, sodass die Vorrichtung aus dem Gehäuse entfernbar ist. Insbesondere weist die Vorrichtung die Elemente des Plasmagenerators auf, die besonders häufig Verschleißerscheinungen zeigen. Dabei handelt es sich insbesondere um den piezoelektrischen Transformator, der bei Betrieb ständig mechanische Schwingungen ausführt, durch die er bei Langzeitbetrieb beschädigt werden kann. Auch durch die Plasmazündungen auf der Ausgangsseite kann es bei Langzeitbetrieb des piezoelektrischen Transformators zu Beschädigungen kommen.

Insbesondere kann der Plasmagenerator derart ausgestaltet sein, dass der piezoelektrische Transformator nur zusammen mit der Halterung und dem Kontaktelement aus dem Plasmagenerator entfernbar ist. Dabei können der piezoelektrische Transformator, die Halterung und das Kontaktelement als Einheit aus dem Plasmagenerator entfernt werden und ersetzt werden. Dadurch kann eine Vorrichtung geschaffen werden, die die oben genannten Vorteile aufweist, wie zum Beispiel stoßfeste Halterung des Transformators, nur minimale Dämpfung der Schwingungen des Transformators oder longitudinale Fixierung ohne Belastung der mechanischen Befestigung der Kontaktelemente an dem Transformator.

Ist die Vorrichtung derart ausgestaltet, dass diese aus dem Plasmagenerator herausnehmbar und austauschbar ist, so können nach einem Austausch der Vorrichtung die weiteren Bauelemente des Plasmagenerators weiter verwendet werden.

Die Halterung der Vorrichtung kann in dem Gehäuse des Plasmagenerators beispielsweise durch eine Schraubverbindung oder eine Rastverbindung befestigt sein. Die Verbindung kann dabei derart ausgestaltet sein, dass sie nicht durch Stöße und Vibrationen bei Betrieb des Plasmagenerators gelöst wird, jedoch durch einen Nutzer des Plasmagenerators lösbar ist.

Die Vorrichtung kann alternativ in dem Gehäuse durch eine stoffliche Verbindung befestigt sein, beispielsweise durch ein Kleben oder ein Löten. Eine solche Verbindung ist zwar nicht lösbar, kann jedoch bei bestimmten Anwendungen, die eine besonders hohe Stabilität der Befestigung erfordern, vorteilhaft sein.

In dem Gehäuse kann eine Ansteuerschaltung zur Ansteuerung des piezoelektrischen Transformators angeordnet sein, die mit dem piezoelektrischen Transformator über das Kontaktelement elektrisch kontaktiert ist. Wird die Halterung in dem Gehäuse befestigt, so kann dabei gleichzeitig ein elektrischer Kontakt zwischen dem Kontaktelement und der Ansteuerschaltung ausgebildet werden.

Im Folgenden wird die vorliegende Erfindung anhand der Figuren weiter beschrieben.
Figur 1 zeigt einen piezoelektrischen Transformator in einer perspektivischen Ansicht.
Figur 2 zeigt eine Vorrichtung zur Erzeugung eines Atmosphärendruck-Plasmas.
Figur 3 zeigt einen Ausschnitt eines Querschnitts durch die in Figur 2 gezeigte Vorrichtung.
Figur 4 zeigt eine perspektivische Ansicht der Vorrichtung.
Figuren 5 bis 10 zeigen einen Querschnitt durch eine Vorrichtung gemäß alternativen Ausführungsbeispielen.
Figur 11 zeigt eine Seitenansicht eines piezoelektrischen Transformators und eines Kontaktelements.
Figuren 12 bis 15 zeigen die Vorrichtung zur Erzeugung eines Atmosphärendruck-Plasmas gemäß einem weiteren Ausführungsbeispiel.
Figuren 16 bis 19 zeigen die Vorrichtung gemäß einem weiteren Ausführungsbeispiel.
Figur 20 zeigt einen Querschnitt durch die Vorrichtung gemäß einer alternativen Variante des in den Figuren 16 bis 19 gezeigten Ausführungsbeispiels.
Figur 21 zeigt einen Querschnitt durch die Vorrichtung gemäß einem weiteren Ausführungsbeispiel.
Figur 22 zeigt eine alternative Variante des in den Figur 21 gezeigten Ausführungsbeispiels.

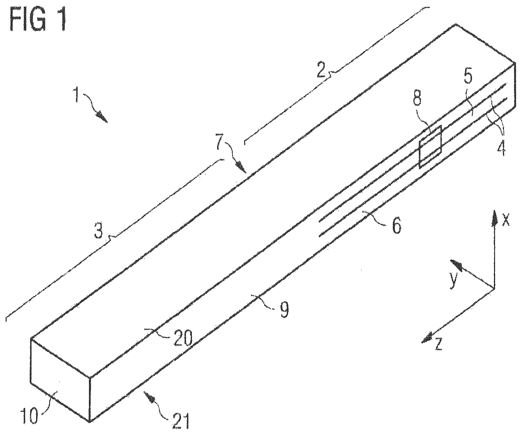

Figur 1 zeigt einen piezoelektrischen Transformator 1 in einer perspektivischen Ansicht. Der piezoelektrische Transformator 1 kann insbesondere in einer Vorrichtung zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer longitudinalen Richtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der longitudinalen Richtung z des piezoelektrischen Transformators 1. Die Elektroden 4 sind in einer Stapelrichtung x, die senkrecht zu der longitudinalen Richtung z ist, abwechselnd mit einem piezoelektrischen Material 5 gestapelt. Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Ferner weist der piezoelektrische Transformator 1 eine dritte Seitenfläche 20 und eine vierte Seitenfläche 21 auf, die einander gegenüberliegen und die senkrecht zu der ersten Seitenfläche 6 und der zweiten Seitenfläche 7 angeordnet sind. Die Flächennormalen der dritten und der vierten Seitenflächen 20, 21 zeigen jeweils in Stapelrichtung x.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich ist in der longitudinalen Richtung z polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der longitudinalen Richtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

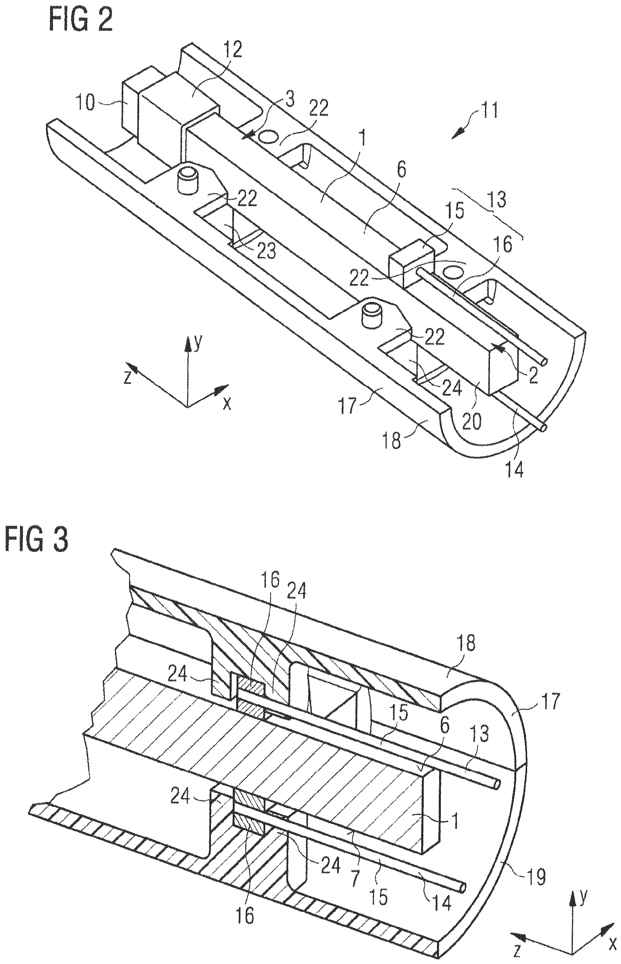

Figur 2 zeigt eine Vorrichtung 11 zur Erzeugung eines Atmosphärendruck-Plasmas. Die Vorrichtung 11 weist den in Figur 1 gezeigten piezoelektrischen Transformator 1 auf. Der piezoelektrische Transformator 1 weist hier zusätzlich eine Isolierung 12 auf, die im Ausgangsbereich 3 des piezoelektrischen Transformators 1 angeordnet ist, wobei die Isolierung 12 die Seitenflächen des Transformators 1 im Ausgangsbereich 3 zumindest teilweise bedeckt und die ausgangsseitige Stirnseite 10 frei von der Isolierung 12 ist. Die Isolierung kann beispielsweise durch einen Schrumpfschlauch gebildet werden. Die Isolierung 12 verhindert, dass entlang der ausgangsseitigen Kanten des piezoelektrischen Transformators 1 unerwünschte Plasmazündungen entstehen.

Ferner weist die Vorrichtung ein erstes Kontaktelement 13 und ein zweites Kontaktelement 14 auf. Das erste Kontaktelement 13 ist mit der ersten Außenelektrode 8 des piezoelektrischen Transformators 1 verbunden. Das zweite Kontaktelement 14 ist mit der zweiten Außenelektrode des piezoelektrischen Transformators 1 verbunden. Über das erste und das zweite Kontaktelement 13, 14 kann an die erste und die zweite Außenelektrode des piezoelektrischen Transformators 1 eine Wechselspannung angelegt werden.

Die Kontaktelemente 13, 14 weisen jeweils einen Draht 15 auf, an dessen einen Ende ein Block 16 angeordnet ist. Der Block 16 der Kontaktelemente 13, 14 ist an der jeweiligen Außenelektrode 8 durch eine nicht-lösbare Befestigung befestigt. Der Block 16 kann beispielsweise durch Löten, Bonden, Kleben oder Mikrosilber-Sintern an der Außenelektrode 8 des piezoelektrischen Transformators 1 befestigt sein. Der Block 16 und der Draht 15 weisen ein leitfähiges Material auf, beispielsweise Kupfer.

Ferner weist die Vorrichtung 11 eine Halterung 17 auf. Die Halterung 17 kann zwei Halbschalen 18, 19 aufweisen. In Figur 2 ist nur eine erste Halbschale 18 der Halterung 17 gezeigt, um eine Darstellung der Verbindung des piezoelektrischen Transformators 1 mit der Halterung 17 zu ermöglichen. Die zweite Halbschale 19 kann identisch zu der in Figur 2 gezeigten Halbschale 18 sein. Bei den Halbschalen 18, 19 handelt es sich um Spritzgusselemente.

Die Halterung 17 weist Stützelemente 22 auf. Die dritte und die vierten Seitenfläche 20, 21 des piezoelektrischen Transformators 1 liegen jeweils an einem der Stützelemente 22 an. In Richtung zu dem piezoelektrischen Transformator 1 hin sind die Stützelemente 22 jeweils keilförmig zugespitzt, sodass sie an dem piezoelektrischen Transformator 1 nahezu linienförmig anliegen. Die Stützelemente 22 sind dabei entlang der longitudinalen Richtung z an den Positionen angeordnet, an denen sich bei Betrieb des Transformators 1 mit seiner Resonanzfrequenz oder mit harmonischen Oberschwingungen Schwingungsknoten ausbilden. Dementsprechend sind die Stützelemente 22 bei einer Länge von einem Viertel der Länge des piezoelektrischen Transformators 1 und bei drei Vierteln der Länge des piezoelektrischen Transformators 1 angeordnet.

Durch die Anordnung der Stützelemente 22 an den Schwingungsknoten des piezoelektrischen Transformators 1 sowie durch ihre keilförmige Ausgestaltung wird es ermöglicht, dass die Stützelemente 22 eine Bewegung des piezoelektrischen Transformators 1 in longitudinaler Richtung z nur minimal dämpfen.

Der piezoelektrische Transformator 1 liegt in Stapelrichtung x beidseitig unmittelbar an je einem der zwei Stützelemente 22 an. In Stapelrichtung x liegen die Stützelemente 22 einander gegenüber. Auf diese Weise werden Bewegungen des piezoelektrischen Transformators 1 relativ zu der Halterung 17 in Stapelrichtung x verhindert.

Ferner weist die Halterung 17 weitere Stützelemente 23 auf, zwischen denen der piezoelektrische Transformator 1 in einer y-Richtung eingeschlossen ist, wobei die y-Richtung senkrecht zur Stapelrichtung x und senkrecht zur longitudinalen Richtung z ist. In y-Richtung kann der piezoelektrische Transformator 1 beidseitig unmittelbar an je einem Stützelement 23 anliegen. Die Stützelemente 23 liegen einander in y-Richtung gegenüber. Auch diese Stützelemente 23 laufen in einer Richtung zu dem piezoelektrischen Transformator 1 hin keilförmig zu und liegen an diesem nahezu linienförmig an. Durch das Anliegen an den Stützelementen 23 wird eine Bewegung des piezoelektrischen Transformators 1 relativ zu der Halterung 17 in y-Richtung verhindert.

Figur 3 zeigt einen Ausschnitt eines Querschnitts durch die Vorrichtung 11 zur Erzeugung des Atmosphärendruck-Plasmas. In Figur 3 ist die erste Halbschale 18 und die zweite Halbschale 19 der Halterung 17 gezeigt. Es ist zu erkennen, dass jede der Halbschalen 18, 19 Vorsprünge 24 aufweist, wobei der Block 16 des Kontaktelements 13, 14 in longitudinaler Richtung z zwischen zwei Vorsprüngen 24 angeordnet ist. Dabei liegen die Kontaktelemente 13, 14 in der longitudinalen Richtung z jeweils sowohl an einem ersten Vorsprung 24 als auch an einem zweiten Vorsprung 24 an. Dementsprechend wird eine Bewegung der Kontaktelemente 13, 14 in longitudinaler Richtung z relativ zu der Halterung 17 verhindert. Es handelt sich um eine formschlüssige Verbindung der Kontaktelemente 13, 14 mit der Halterung 17. Da die Kontaktelemente fest mit der jeweiligen Außenelektrode 8 des piezoelektrischen Transformators 1 verbunden sind, ist auch eine Bewegung des piezoelektrischen Transformators 1 in longitudinaler Richtung z relativ zu der Halterung 17 nicht möglich.

Während des Betriebs führt der piezoelektrische Transformator 1 Schwingungen in longitudinaler Richtung z aus. Durch die formschlüssige Verbindung der Kontaktelemente 13, 14 mit der Halterung 17 wird sichergestellt, dass durch diese Schwingung der Transformator 1 nicht relativ zu der Halterung 17 bewegt wird. Die formschlüssige Verbindung ist ferner stoßfest, so dass der piezoelektrische Transformator 1 auch dann nicht relativ zu der Halterung 17 bewegt wird, wenn die Vorrichtung 11 einem Stoß ausgesetzt ist, beispielsweise infolge eines Herunterfallens.

Durch die keilförmige Form der Stützelemente 22, 23 werden Bewegungen des piezoelektrischen Transformators 1 relativ zur Halterung 17 in Richtungen x, y senkrecht zur longitudinalen Richtung z vermieden, ohne dass die Befestigung der Kontaktelemente 13, 14 an dem piezoelektrischen Transformator 1 mechanisch belastet wird. Bei dieser Befestigung kann es sich beispielsweise um Lötstellen handeln. Eine mechanische Belastung tritt vielmehr an den Verbindungsstellen der Kontaktelemente 13, 14 mit der Halterung 17 auf. Dadurch wird sichergestellt, dass der piezoelektrische Transformator 1 selbst nicht durch die mechanischen Belastungen zerstört wird und dass die elektrische Kontaktierung des piezoelektrischen Transformators 1 nicht gestört wird.

Die beiden Halbschalen 18, 19 der Halterung 17 können identisch sein. Die beiden Halbschalen 18, 19 sind ferner derart aneinander befestigt, dass sie nicht zerstörungsfrei voneinander getrennt werden können. Beispielsweise können die beiden Halbschalen 18, 19 miteinander verklebt sein.

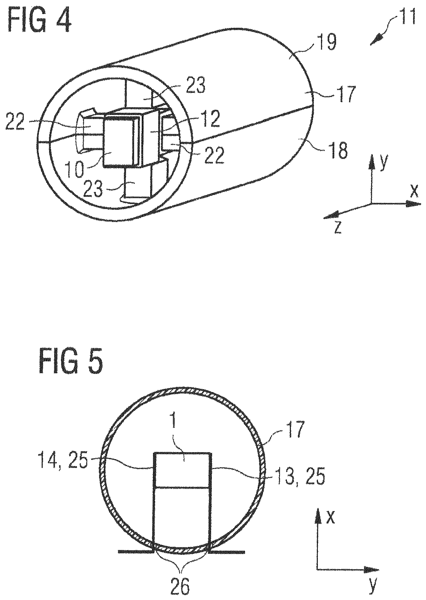

Figur 4 zeigt eine perspektivische Ansicht der Vorrichtung 11. In Figur 4 ist der Ausgangsbereich 3 des piezoelektrischen Transformators 1 zu erkennen. Ferner sind in Figur 4 die Stützelemente 22, 23 gezeigt, die bei einer longitudinalen Länge von drei Vierteln des piezoelektrischen Transformators 1 angeordnet sind. Zwei Stützelemente 22 verhindern eine Bewegung des piezoelektrischen Transformators 1 in Stapelrichtung x relativ zu der Halterung 17 und zwei Stützelemente 23 verhindern eine Bewegung des piezoelektrischen Transformators 1 in y-Richtung relativ zu der Halterung 17.

Die Vorrichtung 11 kann insbesondere in einem Plasmagenerator eingesetzt werden. Dabei kann die Halterung 17 in einem Gehäuse des Plasmagenerators befestigt werden. Die Vorrichtung 11 ist derart ausgestaltet, dass die Vorrichtung 11 aus dem Plasmagenerator wieder entnommen werden kann und durch eine andere gleichartige Vorrichtung 11 ausgetauscht werden kann. Dementsprechend kann die Vorrichtung 11 in dem Gehäuse des Generators lösbar befestigt werden, beispielsweise durch eine Schraub- oder eine Rastverbindung.

Der Plasmagenerator weist neben der Vorrichtung 11 weitere Bauelemente auf, beispielsweise eine Ansteuerschaltung. Der piezoelektrische Transformator 1 kann über die Kontaktelemente 13, 14 mit der Ansteuerschaltung elektrisch verbunden werden. Dabei kann die Ansteuerschaltung über die Kontaktelemente 13, 14 eine Wechselspannung an den Eingangsbereich 2 des piezoelektrischen Transformators 1 anlegen.

In einem Plasmagenerator ist insbesondere der piezoelektrische Transformator 1 ein Bauteil, das Verschleißerscheinungen zeigen kann und das dementsprechend vorteilhafterweise austauschbar sein sollte. Die Vorrichtung 11 ermöglicht es, in dem Plasmagenerator den piezoelektrischen Transformator 1 zusammen mit der Halterung 17 und den Kontaktelementen 13, 14 auszutauschen, ohne dabei weitere Bauelemente des Plasmagenerators tauschen zu müssen. Gleichzeitig ermöglicht es die Vorrichtung 11, den piezoelektrischen Transformator 1 in einer definierten Position zu halten, ohne ihn in seinem Betrieb erheblich zu beeinträchtigen, insbesondere ohne die Schwingungen des piezoelektrischen Transformators 1 wesentlich zu dämpfen.

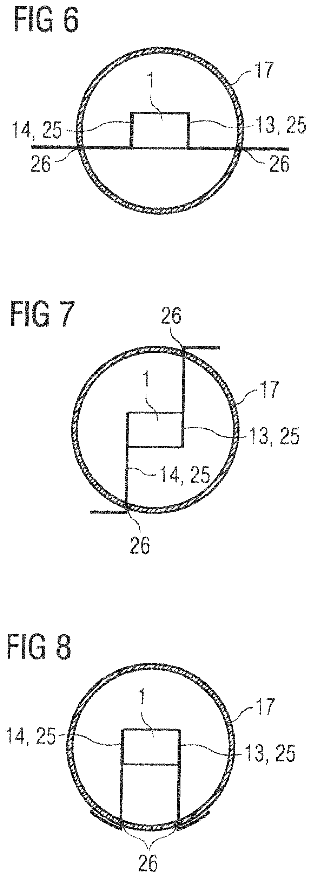

Die Figuren 5 bis 10 zeigen einen Querschnitt durch eine Vorrichtung 11 gemäß alternativen Ausführungsbeispielen. Hierbei werden die Kontaktelemente 13, 14 durch ein Kupfer-Invar-Kupfer aufweisendes Blech 25 gebildet. Die Kontaktelemente 13, 14 sind fest an den Außenelektroden des piezoelektrischen Transformators 1 befestigt, beispielsweise durch Löten, Bonden, Kleben oder Mikrosilber-Sintern.

Die Halterung 17 weist schlitzförmige Ausnehmungen 26 auf. Die Kontaktelemente 13, 14 sind in den Ausnehmungen 26 angeordnet. Die Kontaktelemente 13, 14 werden durch die Ausnehmungen 26 aus dem Inneren der Halterung 17 in das Äußere der Halterung 17 herausgeführt. In den Ausnehmungen 26 sind die Kontaktelemente 13, 14 formschlüssig befestigt. Dabei werden Bewegungen der Kontaktelemente 13, 14 in longitudinaler Richtung x relativ zu der Halterung 17 vermieden. Zusätzlich können die Kontaktelemente 13, 14 mit der Halterung 17 an den Ausnehmungen 26 verklebt werden, um eine stabilere Befestigung zu ermöglichen.

Die Figuren 5 bis 10 zeigen verschiedene Formen der Kontaktelemente 13, 14. Dabei sind die Kontaktelemente 13, 14 jeweils flächig an der jeweiligen Außenelektrode 8 des piezoelektrischen Transformators 1 befestigt.

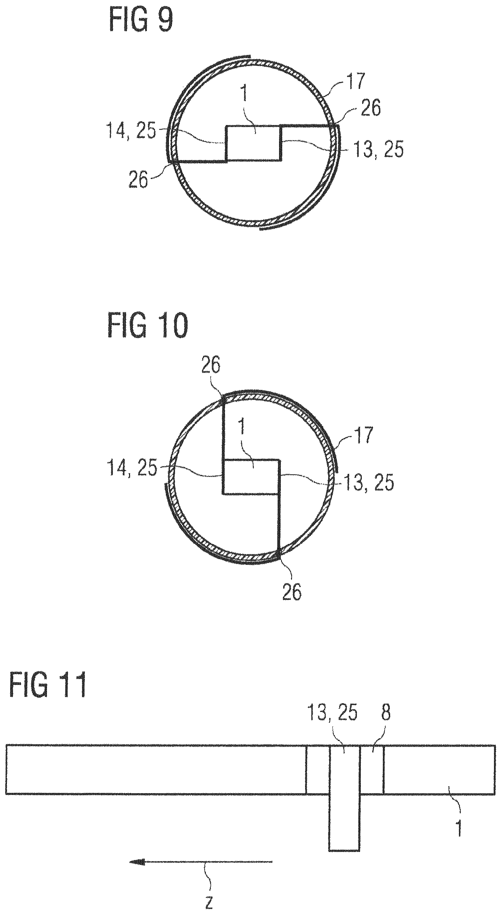

Figur 11 zeigt eine Seitenansicht des piezoelektrischen Transformators 1 und eines Kontaktelements 13. Auch hier ist zu sehen, dass das Kontaktelement 13 flächig mit der Außenelektrode 8 des piezoelektrischen Transformators 1 verbunden ist. Dadurch kann sichergestellt werden, dass die Befestigung des Kontaktelements 13 an der Außenelektrode 8 stabil ist.

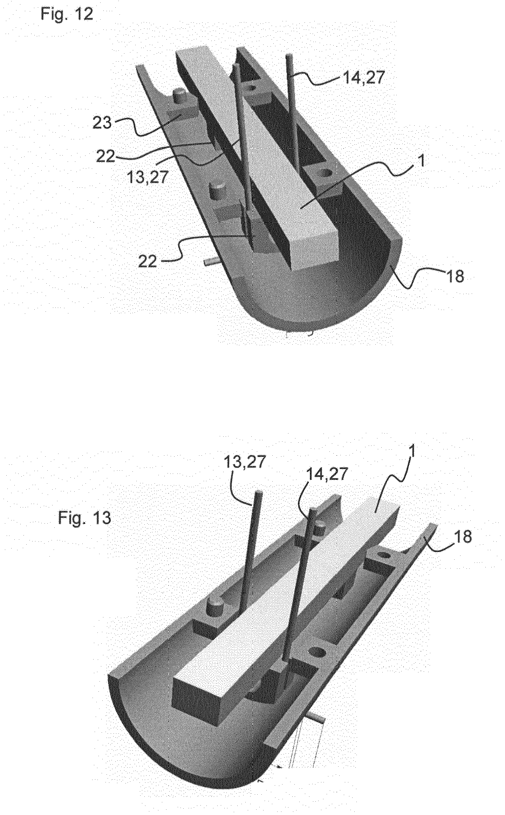

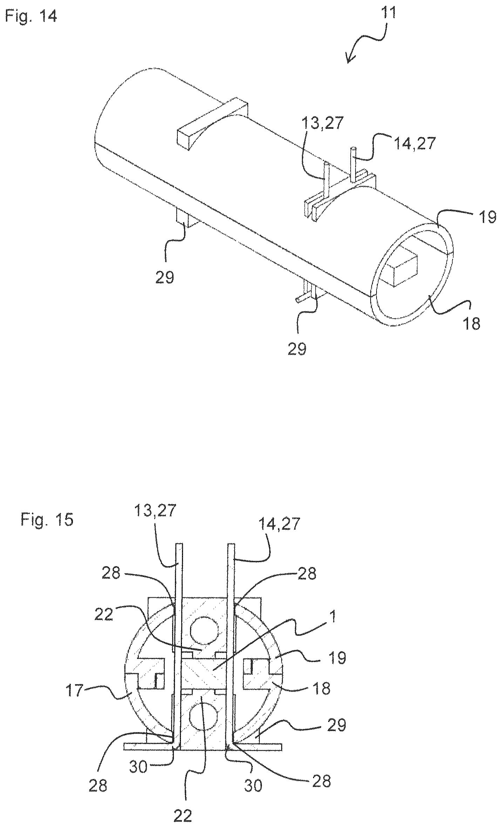

Die Figuren 12 bis 15 zeigen die Vorrichtung 11 gemäß einem weiteren Ausführungsbeispiel. Figur 12 und Figur 13 zeigen jeweils eine perspektivische Ansicht der Vorrichtung 11, wobei die zweite Halbschale 19 der Halterung 17 nicht gezeigt ist, um die Darstellung der innerhalb der Halterung 17 angeordneten Elemente zu ermöglichen. Figur 14 zeigt eine perspektivische Darstellung der Vorrichtung 11, wobei die zweite Halbschale 19 ebenfalls gezeigt ist. Figur 15 zeigt einen Querschnitt durch die in Figur 14 gezeigt Vorrichtung 11.

Die Kontaktelemente 13, 14 werden hier durch zwei Drähte 27 gebildet. Die Halterung 17 weist vier Öffnungen 28 auf. In der ersten Halbschale 18 sind zwei Öffnungen 28 angeordnet. In der zweiten Halbschale 19 sind ebenfalls zwei Öffnungen 28 angeordnet. Jeder der beiden Drähte 27 verläuft durch eine Öffnung 28 in der ersten Halbschale 18 und eine Öffnung 28 in der zweiten Halbschale 19. Der Durchmesser der Öffnungen 28 ist an den Durchmesser der Drähte 27 angepasst, so dass die Drähte 27 formschlüssig mit der Halterung 17 verbunden sind. Die Drähte 27 weisen innerhalb der Halterung 17 einen linearen Verlauf auf.

Die Drähte 27 sind ferner mit dem piezoelektrischen Transformator 1 verlötet. Insbesondere ist einer der Drähte 27 mit der ersten Außenelektrode 8 des piezoelektrischen Transformators 1 verlötet und der andere der Drähte 27 ist mit der zweiten Außenelektrode verlötet. Auf Grund des Formschlusses zwischen den Drähten 27 und der Halterung 17 sowie der Verlötung der Drähte 27 mit dem piezoelektrischen Transformator 1 kann der piezoelektrische Transformator 1 sich nicht in der longitudinalen Richtung z relativ zu der Halterung 17 bewegen. Ferner wird durch den Formschluss der Drähte 27 mit der Halterung 17 sowie der Verlötung der Drähte 27 mit dem Transformator 1 eine Bewegung des Transformators 1 im Eingangsbereich 2 in der y-Richtung y relativ zu der Halterung 17 verhindert.

Die Halterung 17 weist ferner Stützelemente 22, auf denen der piezoelektrische Transformator 1 aufliegt und die eine Bewegung des piezoelektrischen Transformators 1 relativ zu der Halterung 17 in die Stapelrichtung x verhindern, sowie Stützelemente 23, die eine Bewegung des piezoelektrischen Transformators 1 in y-Richtung y verhindern. Zwei Stützelementen 22 sind im Eingangsbereich 2 des Transformators 1 bei einer Länge von einem Viertel der Länge des piezoelektrischen Transformators 1 angeordnet. Die dritte und die vierte Seitenfläche 20, 21 des Transformators 1 liegen an den Stützelementen 22 an. Weitere Stützelemente 22, 23 sind im Ausgangsbereich 3 des Transformators 1 bei einer Länge von drei Vierteln des Transformators 1 angeordnet. Hier liegen die erste Seitenfläche 6, die zweite Seitenfläche 7, die dritte Seitenfläche 20 und die vierte Seitenfläche 21 jeweils auf einem Stützelement 22, 23 auf.

Ferner weist die Halterung an ihrer Außenseite Vorsprünge 29 auf. Diese dienen zur Oberflächenmontage (englisch: SMD-Montage; SMD = Surface Mounted Device) der Vorrichtung 11. Die Drähte 27, die aus den Öffnungen 28 in der ersten Halbschale 18 heraustreten, weisen außerhalb der Halterung 17 jeweils einen Knick 30 um 90° auf. Diese abgewinkelte Form der Drähte 27 dient ebenfalls dazu, die Oberflächenmontage der Vorrichtung 11 zu ermöglichen.

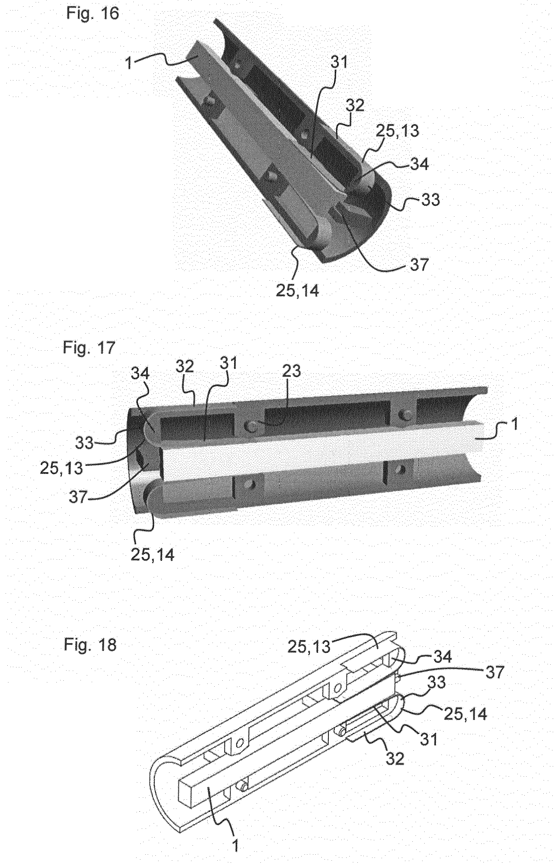

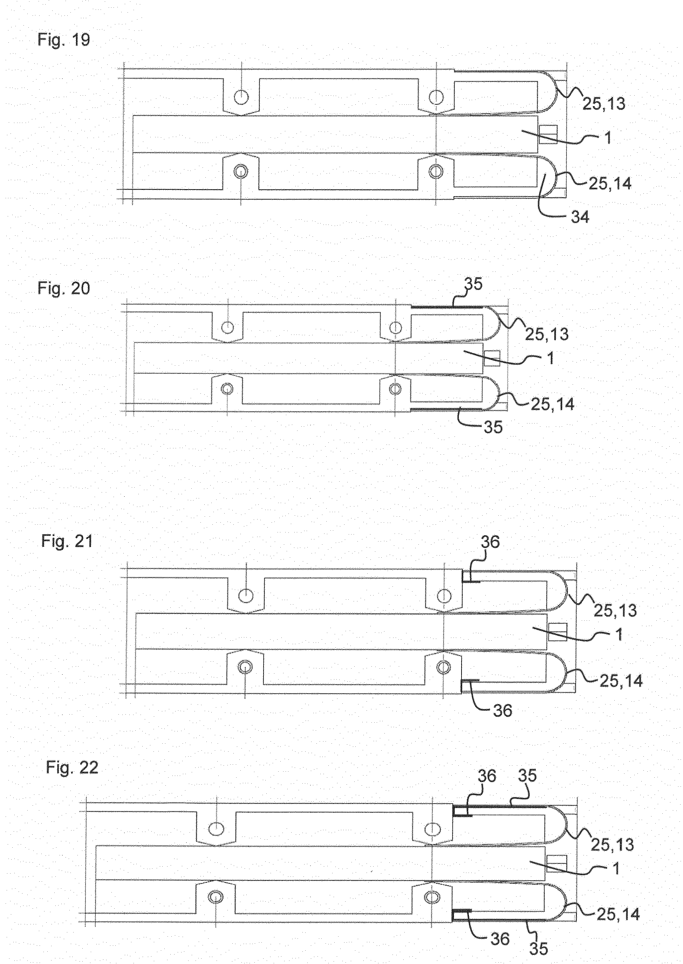

Die Figuren 16 bis 19 zeigen die Vorrichtung 11 gemäß einem weiteren Ausführungsbeispiel. Die Figuren 16, 17 und 18 zeigen jeweils eine perspektivische Ansicht der Vorrichtung 11, wobei die zweite Halbschale 19 der Halterung 17 nicht gezeigt ist, um die Darstellung der innerhalb der Halterung 17 angeordneten Elemente zu ermöglichen. Figur 19 zeigt einen Querschnitt durch die in den Figur 16 bis 18 gezeigt Vorrichtung 11.

Das Kontaktelement 13, 14 weist in diesem Ausführungsbeispiel ein Blech 25 auf. Das Blech 25 besteht aus einer KupferSchicht, einer Invar-Schicht und einer weiteren KupferSchicht, die in dieser Reihenfolge übereinander angeordnet sind.

Das Blech 25 weist eine U-Form auf. Das Blech 25 weist einen ersten Abschnitt 31 und einen zweiten Abschnitt 32 auf, die über einen mittleren halbkreisförmigen Abschnitt 33 miteinander verbunden sind. Der erste Abschnitt 31 des Blechs 25 liegt am Eingangsbereich 2 des piezoelektrischen Transformators 1 an. Der erste Abschnitt 31 kann mit dem piezoelektrischen Transformator 1 fest verbunden sein, beispielsweise durch ein Lötverbindung, eine Bondverbindung, eine Klebeverbindung oder eine Sinterverbindung mit Mikrosilber.

Die Halterung 17 weist ferner ein Führungselement 34 auf, das die Anordnung des Blechs 25 vorgibt. Das Führungselement 34 weist einen halbkreisförmigen Abschnitt auf, an dem der mittlere halbkreisförmige Abschnitt 33 des Blechs 25 anliegt.

Die Halterung 17 weist ferner einen durchgängigen Steg 37 auf, der das Herausbewegen des Transformators 1 entlang der longitudinalen Richtung z in Richtung des Eingangsbereichs 2 relativ zur Halterung 17 verhindert. Der Steg 37 liegt an einer eingangsseitigen Stirnseite des Transformators 1 an, wobei die eingangsseitige Stirnseite vom Ausgangsbereich 3 des Transformators 1 weg weist.

Der zweite Abschnitt 32 des Blechs 25 ist ferner an der Außenseite der Halterung 17 angeordnet. Die Halterung 17 weist in dem Bereich, in dem das Blech 25 angeordnet ist, einen Außendurchmesser auf, der geringfügig kleiner ist als der Außendurchmesser in den übrigen Bereichen der Halterung 17.

Auf Grund des Stegs 37, der ein Herausbewegen des Transformators 1 in der longitudinalen Richtung in Richtung des Eingangsbereichs 2 verhindert, und der U-Form des Blechs 25, das an dem halbkreisförmigen Führungselement 34 der Halterung 17 und der Außenseite der Halterung anliegt und das ferner mit dem piezoelektrischen Transformator 1 verbunden ist, ergibt sich ein Formschluss. Hiermit werden auch Bewegungen des piezoelektrischen Transformators 1 in die longitudinale Richtung z relativ zu der Halterung 17 verhindert.

Die Vorrichtung 11 kann nunmehr mittels einer Steckverbindung oder einer Schraubverbindung in eine Fassung eingesteckt bzw. eingeschraubt werden, wobei die Fassung elektrische Kontakte aufweist, die das Blech 25 elektrisch kontaktieren.

Die Halterung 17 weist ferner Stützelemente 22, 23 auf, die im Eingangsbereich 2 bei einer Länge von einem Viertel der Länge des Transformators 1 und im Ausgangsbereich 3 bei einer Länge von drei Vierteln der Länge des Transformators 1 angeordnet sind. Jede der Seitenflächen 6, 7, 20, 21 des Transformators 1 liegt an jeweils einem Stützelement 22, 23 an.

Figur 20 zeigt einen Querschnitt durch die Vorrichtung 11 gemäß einer alternativen Variante des in den Figuren 16 bis 19 gezeigten Ausführungsbeispiels. Bei der alternativen Variante ist zusätzlich eine Klebeschicht 35 auf der Außenseite der Halterung 17 aufgebracht, die den zweiten Abschnitt 32 des Blechs 25 mit der Halterung 17 verklebt.

Figur 21 zeigt einen Querschnitt durch die Vorrichtung 11 gemäß einem weiteren Ausführungsbeispiel. Das in Figur 21 gezeigte Ausführungsbeispiel unterscheidet sich von dem in den Figuren 16 bis 19 gezeigten Ausführungsbeispiel dadurch, dass der zweite Abschnitt 32 des Blechs 25 ferner einen gebogenen Teilabschnitt 36 aufweist. Insbesondere weist der gebogene Teilabschnitt 36 zwei Knicke auf, an denen das Blech 25 jeweils um einen Winkel von 90° umgebogen ist. Durch den gebogenen Teilabschnitt 36 ergibt sich eine zusätzliche formschlüssige Verbindung zwischen der Halterung 17 und dem Blech 25. Die zusätzliche formschlüssige Verbindung trägt weiter dazu bei, Bewegungen des piezoelektrischen Transformators 1 in die longitudinale Richtung z relativ zu der Halterung 17 auszuschließen.

Figur 22 zeigt eine alternative Variante des in den Figur 21 gezeigten Ausführungsbeispiels. Bei der alternativen Variante ist zusätzlich eine Klebeschicht 35 auf der Außenseite der Halterung 17 aufgebracht, die den zweiten Abschnitt 32 des Blechs 25 mit der Halterung 17 verklebt. Ferner ist die Klebeschicht 35 auch auf dem Bereich der Halterung 17, an dem der umgebogene Teilabschnitt 36 anliegt, aufgebracht.

Gemäß einer weiteren Ausführungsform können die in den Figuren 21 und 22 gezeigten Ausführungsvarianten der Figuren 16 bis 19 auch unter Weglassen des Stegs 37 auf der Eingangsseite der Halterung 17 realisiert werden.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: erste Außenelektrode
- 9: piezoelektrisches Material
- 10: ausgangsseitige Stirnseite
- 11: Vorrichtung zur Erzeugung eines Atmosphärendruck-Plasmas
- 12: Isolierung
- 13: erste Kontaktelement
- 14: zweite Kontaktelement
- 15: Draht
- 16: Block
- 17: Halterung
- 18: erste Halbschale
- 19: zweite Halbschale
- 20: dritte Seitenfläche
- 21: vierte Seitenfläche
- 22: Stützelement
- 23: Stützelement
- 24: Vorsprung
- 25: Blech
- 26: Ausnehmung
- 27: Draht
- 28: Öffnung
- 29: Vorsprung
- 30: Knick
- 31: erster Abschnitt
- 32: zweiter Abschnitt
- 33: mittlerer Abschnitt
- 34: Führungselement
- 35: Klebeschicht
- 36: gebogener Teilabschnitt
- 37: Steg

- x: Stapelrichtung
- y: y-Richtung
- z: longitudinale Richtung

## Patentansprüche

1. Vorrichtung (11) zur Erzeugung eines Atmosphärendruck-Plasmas, aufweisend
- einen piezoelektrischen Transformator (1), der einen Eingangsbereich (2) und einen Ausgangsbereich (3) aufweist, wobei der Eingangsbereich (2) dazu ausgestaltet ist, eine angelegte Wechselspannung in eine mechanische Schwingung zu wandeln, wobei der Ausgangsbereich (3) dazu ausgestaltet ist, eine mechanische Schwingung in eine elektrische Spannung zu wandeln und wobei der Ausgangsbereich (3) sich in einer longitudinalen Richtung (z) an den Eingangsbereich (2) anschließt,
- ein Kontaktelement (13, 14), das an dem piezoelektrischen Transformator (1) befestigt ist und das dazu ausgelegt ist, an den Eingangsbereich (2) eine Wechselspannung anzulegen, und
- eine Halterung (17), wobei das Kontaktelement (13, 14) durch eine formschlüssige Verbindung derart mit der Halterung (17) verbunden ist, dass eine Bewegung des piezoelektrischen Transformators (1) in longitudinaler Richtung (z) relativ zu der Halterung (17) verhindert wird, **dadurch gekennzeichnet,**
**dass** das Kontaktelement (13, 14) an dem piezoelektrischen Transformator (1) durch eine nicht-lösbare Befestigung befestigt ist.

2. Vorrichtung (11) gemäß dem vorherigen Anspruch,
wobei die Halterung (17) zwei Vorsprünge (24) aufweist, wobei das Kontaktelement (13, 14) in longitudinaler Richtung (z) beidseitig unmittelbar an je einem der zwei Vorsprünge (24) anliegt.

3. Vorrichtung (11) gemäß einem der vorherigen Ansprüche,
wobei die Halterung (17) schlitzförmige Ausnehmungen (26) aufweist, in denen das Kontaktelement (13, 14) angeordnet ist und durch die das Kontaktelement (13, 14) aus einem Inneren der Halterung (17) aus der Halterung (17) herausgeführt wird.

4. Vorrichtung (11) gemäß einem der vorherigen Ansprüche,
wobei das Kontaktelement (13, 14) zwei Drähte (27) aufweist,
wobei die Halterung (17) Öffnungen (28) aufweist, deren Durchmesser einem Durchmesser der Drähte (27) entspricht,
wobei jeder der zwei Drähte (27) durch je zwei Öffnungen (28) in der Halterung (17) verläuft und dadurch formschlüssig mit der Halterung (17) verbunden ist.

5. Vorrichtung (11) gemäß einem der vorherigen Ansprüche,
wobei die Halterung (17) zumindest zwei Stützelemente (22, 23) aufweist, auf denen der piezoelektrische Transformator (1) aufliegt und die eine Bewegung des piezoelektrischen Transformators (1) in eine Richtung (x, y) senkrecht zur longitudinalen Richtung (z) verhindern.

6. Vorrichtung (11) gemäß dem vorherigen Anspruch,
wobei die Stützelemente (22, 23) eine in Richtung zu dem piezoelektrischen Transformator (1) hin keilförmig zugespitzte Form aufweisen und an dem piezoelektrischen Transformator (1) nahezu linienförmig anliegen.

7. Vorrichtung (11) gemäß einem der Ansprüche 5 oder 6,
wobei die Stützelemente (22, 23) derart angeordnet sind, dass sie an dem piezoelektrischen Transformator (1) in longitudinaler Richtung (z) an einer Position anliegen, die einem Viertel der Länge des piezoelektrischen Transformators (1) entspricht
und/oder
wobei die Stützelemente (22, 23) derart angeordnet sind, dass sie an dem piezoelektrischen Transformator (1) in longitudinaler Richtung (z) an einer Position anliegen, die drei Vierteln der Länge des piezoelektrischen Transformators (1) entspricht.

8. Vorrichtung (11) gemäß einem der vorherigen Ansprüche,
wobei die Halterung (17) aus einem Material besteht, das sich überwiegend elastisch verformt.

9. Vorrichtung (11) gemäß einem der vorherigen Ansprüche,
wobei die Halterung (17) zwei miteinander verbundene Halbschalen (18, 19) aufweist.

10. Vorrichtung (11) gemäß dem vorherigen Anspruch,
wobei die beiden Halbschalen (18, 19) identisch sind und
wobei die beiden Halbschalen (18, 19) aus einem Material gefertigt sind.

11. Vorrichtung (11) gemäß einem der vorherigen Ansprüche,
wobei das Kontaktelement (13, 14) ein Kupfer-Invar-Kupfer aufweisendes Blech (25) aufweist.

12. Vorrichtung (11) gemäß dem vorherigen Anspruch,
wobei das Blech (25) einen ersten Abschnitt (31), der an dem piezoelektrischen Transformator (1) anliegt, und einen zweiten Abschnitt (32), der an einer Außenseite der Halterung (17) angeordnet ist, aufweist.

13. Vorrichtung (11) gemäß dem vorherigen Anspruch,
wobei das Blech (25) ferner einen mittleren Abschnitt (33) aufweist, der den ersten Abschnitt (31) mit dem zweiten Abschnitt (32) verbindet, und
wobei das Blech (25) U-förmig gebogen ist.

14. Vorrichtung (11) gemäß einem der Ansprüche 12 oder 13,
wobei der zweite Abschnitt (32) einen gebogenen Teilabschnitt (36) aufweist, der formschlüssig mit der Halterung (17) verbunden ist.

15. Vorrichtung (11) gemäß zumindest einem der Ansprüche 12 bis 14,
wobei die Vorrichtung (11) einen Steg (37) aufweist, der an einer eingangsseitigen Stirnseite des piezoelektrischen Transformators (1) anliegt und dadurch eine Bewegung des piezoelektrischen Transformators (1) in die longitudinale Richtung (z) zu dem Steg (37) hin verhindert.

16. Plasmagenerator,
aufweisend eine Vorrichtung (11) gemäß einem der vorherigen Ansprüche und ein Gehäuse, in dem die Vorrichtung (11) angeordnet ist.

17. Plasmagenerator gemäß dem vorherigen Anspruch,
wobei die Vorrichtung (11) lösbar in dem Gehäuse befestigt ist, so dass die Vorrichtung (11) aus dem Gehäuse entfernbar ist.

18. Plasmagenerator gemäß einem der Ansprüche 16 oder 17,
wobei die Halterung (17) in dem Gehäuse durch eine Schraubverbindung oder eine Rastverbindung befestigt ist.

19. Plasmagenerator gemäß dem Anspruch 16,
wobei die Vorrichtung (11) in dem Gehäuse durch eine stoffliche Verbindung befestigt ist.

20. Plasmagenerator gemäß einem der Ansprüche 16 bis 19,
wobei in dem Gehäuse eine Ansteuerschaltung zur Ansteuerung des piezoelektrischen Transformators (1) angeordnet ist, die mit dem piezoelektrischen Transformator (1) über das Kontaktelement (13, 14) elektrisch kontaktiert ist.

## Claims

1. Device (11) for generating an atmospheric pressure plasma, having
- a piezoelectric transformer (1), which has an input region (2) and an output region (3), the input region (2) being configured to convert an applied AC voltage into a mechanical oscillation, the output region (3) being configured to convert a mechanical oscillation into an electrical voltage, and the output region (3) adjoining the input region (2) in a longitudinal direction (z),
- a contact element (13, 14), which is fastened to the piezoelectric transformer (1) and is configured to apply an AC voltage to the input region (2), and
- a holder (17), the contact element (13, 14) being connected to the holder (17) by a form-fitting connection in such a way as to prevent movement of the piezoelectric transformer (1) in the longitudinal direction (z) relative to the holder (17), **characterized in that**
the contact element (13, 14) is fastened to the piezoelectric transformer (1) by a fastening which cannot be undone.

2. Device (11) according to the preceding claim,
wherein the holder (17) has two projections (24), wherein, in the longitudinal direction (z), the contact element (13, 14) rests directly on both sides against each of the two projections (24).

3. Device (11) according to one of the preceding claims,
wherein the holder (17) has slot-shaped openings (26), in which the contact element (13, 14) is arranged and through which the contact element (13, 14) is guided out of the interior of the holder (17) out of the holder (17).

4. Device (11) according to one of the preceding claims,
wherein the contact element (13, 14) has two wires (27),
wherein the holder (17) has orifices (28), the diameter of which corresponds to a diameter of the wires (27),
wherein each of the two wires (27) extends in each case through two orifices (28) in the holder (17) and is thereby connected in form-fitting manner with the holder (17).

5. Device (11) according to one of the preceding claims,
wherein the holder (17) has at least two supporting elements (22, 23), on which the piezoelectric transformer (1) rests and which prevent movement of the piezoelectric transformer (1) in a direction (x, y) perpendicular to the longitudinal direction (z).

6. Device (11) according to the preceding claim,
wherein the supporting elements (22, 23) have a shape tapered in a wedge towards the piezoelectric transformer (1) and rest in virtually linear manner against the piezoelectric transformer (1).

7. Device (11) according to one of claims 5 or 6,
wherein the supporting elements (22, 23) are arranged in such a way that they rest against the piezoelectric transformer (1) in the longitudinal direction (z) at a position which corresponds to a quarter of the length of the piezoelectric transformer (1)
and/or
wherein the supporting elements (22, 23) are arranged in such a way that they rest against the piezoelectric transformer (1) in the longitudinal direction (z) at a position which corresponds to three quarters of the length of the piezoelectric transformer (1).

8. Device (11) according to one of the preceding claims,
wherein the holder (17) consists of a material which predominantly undergoes resilient deformation.

9. Device (11) according to one of the preceding claims,
wherein the holder (17) has two half-shells (18, 19) connected together.

10. Device (11) according to the preceding claim,
wherein the two half-shells (18, 19) are identical and
wherein the two half-shells (18, 19) are made from one material.

11. Device (11) according to one of the preceding claims,
wherein the contact element (13, 14) comprises a metal sheet (25) comprising copper-invar-copper.

12. Device (11) according to the preceding claim,
wherein the metal sheet (25) has a first portion (31) which rests against the piezoelectric transformer (1) and a second portion (32) which is arranged on an outer side of the holder (17) .

13. Device (11) according to the preceding claim,
wherein the metal sheet (25) additionally has a middle portion (33), which connects the first portion (31) with the second portion (32), and
wherein the metal sheet (25) is bent into a U shape.

14. Device (11) according to one of claims 12 or 13,
wherein the second portion (32) has a bent sub-portion (36), which is connected in form-fitting manner with the holder (17) .

15. Device (11) according to at least one of claims 12 to 14,
wherein the device (11) has a bar (37) which rests against an input-side end face of the piezoelectric transformer (1) and thereby prevents movement of the piezoelectric transformer (1) in the longitudinal direction (z) towards the bar (37).

16. Plasma generator,
having a device (11) according to one of the preceding claims and a housing in which the device (11) is arranged.

17. Plasma generator according to the preceding claim,
wherein the device (11) is fastened detachably in the housing, such that the device (11) is removable from the housing.

18. Plasma generator according to one of claims 16 or 17,
wherein the holder (17) is fastened in the housing by a screw connection or a latching connection.

19. Plasma generator according to claim 16,
wherein the device (11) is fastened in the housing by a bonded connection.

20. Plasma generator according to one of claims 16 to 19,
wherein a drive circuit is arranged in the housing to drive the piezoelectric transformer (1), which circuit is electrically contacted with the piezoelectric transformer (1) via the contact element (13, 14).

## Revendications

1. Dispositif (11) pour générer un plasma à la pression atmosphérique, présentant
- un transformateur piézoélectrique (1), qui présente une zone d'entrée (2) et une zone de sortie (3), la zone d'entrée (2) étant conçue pour transformer une tension alternative appliquée en une oscillation mécanique, la zone de sortie (3) étant conçue pour transformer une oscillation mécanique en une tension électrique et la zone de sortie (3) se raccordant, dans la direction longitudinale (z), à la zone d'entrée (2),
- un élément de contact (13, 14) qui est fixé au transformateur piézoélectrique (1) et conçu pour appliquer une tension alternative à la zone d'entrée (2) et
- un support (17), l'élément de contact (13, 14) étant relié par une liaison par complémentarité de forme au support (17) de manière telle qu'un déplacement du transformateur piézoélectrique (1) dans la direction longitudinale (z) par rapport au support (17) est empêché, **caractérisé en ce que** l'élément de contact (13, 14) est fixé au transformateur piézoélectrique (1) par une fixation non amovible.

2. Dispositif (11) selon la revendication précédente,
le support (17) présentant deux saillies (24),
l'élément de contact (13, 14) étant appliqué dans la direction longitudinale (z) des deux côtés directement sur à chaque fois une des deux saillies (24).

3. Dispositif (11) selon l'une quelconque des revendications précédentes,
le support (17) présentant des évidements en forme de fente (26) dans lesquels l'élément de contact (13, 14) est disposé et à travers lesquels l'élément de contact (13, 14) est guidé depuis l'intérieur du support (17) hors du support (17).

4. Dispositif (11) selon l'une quelconque des revendications précédentes,
l'élément de contact (13, 14) présentant deux fils (27),
le support (17) présentant des ouvertures (28) dont le diamètre correspond à un diamètre des fils (27),
chacun des deux fils (27) s'étendant à travers à chaque fois deux ouvertures (28) dans le support (17) et étant ainsi relié au support (17) par complémentarité de forme.

5. Dispositif (11) selon l'une quelconque des revendications précédentes,
le support (17) présentant au moins deux éléments d'appui (22, 23) sur lesquels est placé le transformateur piézoélectrique (1) et qui empêchent un déplacement du transformateur piézoélectrique (1) dans une direction (x, y) perpendiculaire à la direction longitudinale (z).

6. Dispositif (11) selon la revendication précédente,
les éléments d'appui (22, 23) présentant une forme cunéiforme effilée vers le transformateur piézoélectrique (1) et s'appliquant de manière quasiment linéaire sur le transformateur piézoélectrique (1).

7. Dispositif (11) selon l'une quelconque des revendications 5 ou 6,
les éléments d'appui (22, 23) étant disposés de manière telle qu'ils s'appliquent sur le transformateur piézoélectrique (1) dans la direction longitudinale (z) en une position qui correspond à un quart de la longueur du transformateur piézoélectrique (1)
et/ou
les éléments d'appui (22, 23) étant disposés de manière telle qu'ils s'appliquent sur le transformateur piézoélectrique (1) dans la direction longitudinale (z) en une position qui correspond à trois quarts de la longueur du transformateur piézoélectrique (1).

8. Dispositif (11) selon l'une quelconque des revendications précédentes,
le support (17) étant constitué par un matériau qui se déforme principalement de manière élastique.

9. Dispositif (11) selon l'une quelconque des revendications précédentes,
le support (17) présentant deux demi-coques (18, 19) reliées l'une à l'autre.

10. Dispositif (11) selon la revendication précédente,
les deux demi-coques (18, 19) étant identiques et
les deux demi-coques (18, 19) étant fabriquées à partir d'un matériau.

11. Dispositif (11) selon l'une quelconque des revendications précédentes,
l'élément de contact (13, 14) présentant une tôle (25) présentant du cuivre-Invar-cuivre.

12. Dispositif (11) selon la revendication précédente,
la tôle (25) présentant une première partie (31), qui s'applique sur le transformateur piézoélectrique (1), et
une deuxième partie (32) qui est disposée au niveau d'un côté externe du support (17).

13. Dispositif (11) selon la revendication précédente,
la tôle (25) présentant en outre une partie centrale (33) qui relie la première partie (31) à la deuxième partie (32) et
la tôle (25) étant pliée en forme de U.

14. Dispositif (11) selon l'une quelconque des revendications 12 ou 13,
la deuxième partie (32) présentant une partie partielle incurvée (36) qui est reliée au support (17) par complémentarité de forme

15. Dispositif (11) selon au moins l'une quelconque des revendications 12 à 14,
le dispositif (11) présentant une nervure (37), qui s'applique sur une face frontale côté entrée du transformateur piézoélectrique (1) et qui empêche ainsi un déplacement du transformateur piézoélectrique (1) dans la direction longitudinale (z) vers la nervure (37).

16. Générateur de plasma,
présentant un dispositif (11) selon l'une quelconque des revendications précédentes et un boîtier dans lequel est disposé le dispositif (11).

17. Générateur de plasma selon la revendication précédente, le dispositif (11) étant fixé de manière amovible dans le boîtier de telle sorte que le dispositif (11) peut être retiré du boîtier.

18. Générateur de plasma selon l'une quelconque des revendications 16 ou 17,
le support (17) étant fixé dans le boîtier par une liaison vissée ou par une liaison encliquetée.

19. Générateur de plasma selon la revendication 16,
le dispositif (11) étant fixé dans le boîtier par une liaison de matière.

20. Générateur de plasma selon l'une quelconque des revendications 16 à 19,
un circuit de commande pour commander le transformateur piézoélectrique (1), qui est en contact électrique avec le transformateur piézoélectrique (1) via l'élément de contact (13, 14), étant disposé dans le boîtier.
